# EUROPÄISCHE PATENTANMELDUNG

(11) **EP 3 300 470 A1**
(43) Veröffentlichungstag der Anmeldung: **28.03.2018**
(21) Anmeldenummer: 16190118.6
(22) Anmeldetag: 22.09.2016
(51) Int. Cl.: H05K 5/00

(54) **UMRICHTER**

(71) Anmelder: Siemens Aktiengesellschaft, 80333 München (DE)
(72) Erfinder: Schulz, Martin, 80689 München (DE)

(57) **Zusammenfassung**

Die Erfindung beschreibt einen Umrichter zur Umwandlung einer zwischen zwei Eingangsanschlüssen (101, 102) anliegenden Eingangsspannung (U₁) in eine Wechselspannung mit vorbestimmter Amplitude und Frequenz für die Ansteuerung einer ein- oder mehrphasigen Last, mit zumindest zwei seriell miteinander verschalteten Submodulen (SM; SM1,...,SM8) eines Inverterarms. Dabei umfasst jedes Submodul (SM; SM1,...,SM8) einen Schaltungsträger (11) sowie zumindest zwei steuerbare Schaltelemente (S₁, S₂), die auf dem Schaltungsträger (11) elektrisch miteinander verschaltet sind. Ferner weist jedes Submodul (SM; SM1,...,SM8) einen ersten Submodulanschluss (X₁) und einen zweiten Submodulanschluss (X₂) auf. Bei dem Umrichter sind erste Hauptanschlüsse (D) der steuerbaren Schaltelemente (S₁, S₂) der zumindest zwei Submodule (SM; SM1,...,SM8) thermisch an eine Kühlfläche eines Kühlkörpers (12) angeschlossen. Weiterhin ist der zweite Submodulanschluss (X₂) eines ersten der zumindest zwei Submodule (SM; SM1,...,SM8) mit dem ersten Submodulanschluss (X₁) eines zweiten der zumindest zwei Submodule (SM; SM1,...,SM8) verbunden. Der Umrichter zeichnet sich dadurch aus, dass der Kühlkörper (12) eine Anzahl an Kühlkörperteilen (17) umfasst, wobei die Kühlkörperteile (17) elektrisch voneinander isoliert sind. Die elektrische Verbindung des zweiten Submodulanschlusses (X₂) des ersten Submoduls (SM; SM1,...,SM8) mit dem ersten Submodulanschluss (X₁) des zweiten Submoduls ist über ein jeweiliges zugeordnetes Kühlkörperteil (17) des Kühlkörpers (12) realisiert.

## Beschreibung

Die Erfindung betrifft einen Umrichter zur Umwandlung einer zwischen zwei Eingangsanschlüssen anliegenden Eingangsspannung in eine Wechselspannung mit vorbestimmter Amplitude und Frequenz für die Ansteuerung einer ein- oder mehrphasigen Last, mit zumindest zwei seriell miteinander verschalteten Submodulen eines Inverterarms.

Moderne modulare Umrichtertopologien mit Multilevel-Charakteristik bestehen aus identisch aufgebauten Funktionseinheiten, die als Submodule bezeichnet werden und entweder als Halbbrücken- oder Vollbrücken-Submodule aufgebaut sind. Diese werden zur Bereitstellung einer Inverterphase miteinander in Serie geschaltet. Die Verschaltung einer Vielzahl von Halbbrücken-Submodulen in Serie nimmt viel Bauraum ein. Dies sorgt für hohe Kosten des Umrichters.

Im Niederspannungsbereich ist es üblich, modulare Topologien aus, im Allgemeinen Leiterplatten-basierten, Submodulen mit diskreten Leistungshalbleiterschaltelementen aufzubauen. Durch die Nutzung von Leiterplatten ergeben sich weitere Probleme durch die begrenzte Stromtragfähigkeit der Leiterplatten und den, im Vergleich zu Leistungsmodulen, bei denen die Leistungshalbleiterschaltelemente direkt auf einen Träger aufgebracht werden (sog. Direct Copper Bonding (DCB)), schlechteren Kühlbedingungen. In den Verbindungskabeln und den Kontaktstellen zwischen Verbindungskabeln und Leiterplatten entstehen erhebliche Stromwärmeverluste, welche abgeführt werden müssen.

Die elektrische Verbindung zwischen den diskreten Leistungshalbleiterschaltelementen und den Schraub- oder Klemmkontakten der Kabel wird über Kupferbahnen auf den Schaltungsträgern realisiert. Damit die benötigte Stromtragfähigkeit gewährleistet werden kann, kommen teure Hochstromschaltungsträger zum Einsatz. Diese sind als Dickkupfer-Platinen oder Platinen mit eingelegten Kupferprofilen bekannt.

Die Entwärmung bei einem Leiterplatten-basierten Umrichter erfolgt direkt an einem Hauptanschluss (in der Regel dem Drain- oder Kollektoranschluss des Leistungshalbleiterschaltelements). Dazu wird das Leistungshalbleiterschaltelement direkt mit seinem großflächigen Anschlusskontakt an einen Kühlkörper gepresst. Um eine elektrische Verbindung zwischen dem Anschlusskontakt und dem Kühlkörper zu vermeiden, ist zwischen diesen beiden Flächen ein Isolator angeordnet.

Die Stromwärmeverluste in den Verbindungskabeln und in den Kontaktstellen können dadurch minimiert und abgeführt werden, indem größere Kabelquerschnitte und größere Kontakte verwendet werden. Dies führt jedoch wiederum dazu, dass die Aufbau- und Verbindungstechnik sehr groß und schwer ausfällt.

Die Leiterplatten basierte Realisierung eines Umrichters wird gegenüber DCB-basierten Umrichtern dennoch häufig bevorzugt, da ein solcher Umrichter bessere elektrische Eigenschaften aufweist.

Es ist daher Aufgabe der vorliegenden Erfindung, einen Umrichter anzugeben, der baulich und/oder funktional verbessert ist.

Diese Aufgabe wird durch einen Umrichter gemäß den Merkmalen des Patentanspruches 1 gelöst. Vorteilhafte Ausgestaltungen ergeben sich aus den abhängigen Patentansprüchen.

Es wird ein Umrichter zur Umwandlung einer zwischen zwei Eingangsanschlüssen anliegenden Eingangsspannung in eine Wechselspannung mit vorbestimmter Amplitude und Frequenz für die Ansteuerung einer ein- oder mehrphasigen Last vorgeschlagen, mit zumindest zwei seriell miteinander verschalteten Submodulen eines Inverterarms, wobei jedes Submodul folgendes umfasst: einen Schaltungsträger; zumindest zwei steuerbare Schaltelemente, die auf dem Schaltungsträger elektrisch miteinander verschaltet sind; einen ersten Submodulanschluss; einen zweiten Submodulanschluss. Erste Hauptanschlüsse der steuerbaren Schaltelemente der zumindest zwei Submodule sind thermisch an eine Kühlfläche eines Kühlkörpers angeschlossen. Der zweite Submodulanschluss eines ersten der zumindest zwei Submodule ist mit einem ersten Submodulanschluss eines zweiten der zumindest zwei Halbbrücken-Submodule verbunden.

Der Umrichter zeichnet sich dadurch aus, dass der Kühlkörper eine Anzahl an Kühlkörperteilen umfasst, wobei die Kühlkörperteile elektrisch voneinander isoliert sind und die elektrische Verbindung des zweiten Submodulanschlusses des ersten Submoduls mit dem ersten Submodulanschluss des zweiten Submoduls über ein jeweiliges zugeordnetes Kühlkörperteil des Kühlkörpers realisiert ist. Mit anderen Worten bedeutet dies, dass zumindest ein Teil des Stroms von dem zweiten Submodulanschluss des ersten Submoduls zu dem ersten Submodulanschluss des zweiten Submoduls über das Kühlkörperteil fließt, womit das Kühlkörperteil zur Stromleitung genutzt wird.

Hierdurch wird es ermöglicht, einen Umrichter bereitzustellen, bei dem die Submodule Leiterplatten basiert aufgebaut sind. Dadurch lassen sich gute elektrisch Eigenschaften der Submodule und insgesamt des Umrichters bereitstellen. Gleichzeitig wird durch die Anbindung der Submodulanschlüsse an ein zugeordnetes Kühlkörperteil eine exzellente Wärmeabfuhr der in den Halbleiterschaltelementen im Betrieb anfallenden Wärme ermöglicht. Insbesondere ermöglicht es dieser Aufbau, die elektrischen Kontakte direkt zu kühlen, da zwischen den ersten Hauptanschlüssen und dem Kühlkörperteil kein, die Wärmeabfuhr behinderndes Material, wie z.B. eine elektrisch isolierende Isolationsschicht, vorgesehen ist.

Durch eine ausschließliche Kontaktierung der Submodule über die ersten Hauptanschlüsse der zwei Schaltelemente kann die Serienschaltung der Submodule sehr kompakt aufgebaut werden. Insbesondere ist der Befestigungsaufwand minimiert.

Ein weiterer Vorteil besteht darin, dass auf dem Schaltungsträger der Submodule ein verringerter Stromfluss im Vergleich zu einem herkömmlichen Submodul auftritt, da der Strom direkt über die ersten Hauptanschlüsse der Schaltelemente abgenommen wird. Dadurch ergibt sich eine vorteilhafte geringere thermische Beanspruchung der Schaltungsträger.

Gemäß einer zweckmäßigen Ausgestaltung sind die ersten Hauptanschlüsse der Schaltelemente Flächenkontakte, die vollflächig auf das zugeordnete Kühlkörperteil aufgebracht sind. Dadurch wird nicht nur eine große Stromtragfähigkeit sichergestellt. Vielmehr kann auch über die ersten Hauptanschlüsse der Wärmetransfer der in den Schaltelementen erzeugten Wärme in Richtung des Kühlkörperteils des Kühlkörpers erfolgen. Zudem wird die Herstellbarkeit erleichtert, da die ersten Hauptanschlüsse auf einfache Weise mit dem Kühlkörperteil verbunden werden können. Es ist zu betonen, dass hierbei handelsübliche diskrete Leistungshalbleiterschaltelemente als Schaltelemente der Submodule zum Einsatz kommen können.

Gemäß einer weiteren zweckmäßigen Ausgestaltung sind die ersten Hauptanschlüsse der Schaltelemente kraftschlüssig und/oder stoffschlüssig mit dem zugeordneten Kühlkörperteil verbunden. Hierdurch ist eine gute Stromtragfähigkeit zwischen den ersten Hauptanschlüssen von Schaltelementen benachbarter Submodule sichergestellt. Gleichzeitig wird ein guter Wärmetransfer zu dem Kühlkörperteil gewährleistet.

Gemäß einer weiteren zweckmäßigen Ausgestaltung sind die ersten Hauptanschlüsse der Schaltelemente unmittelbar mit dem zugeordneten Kühlkörperteil verbunden. Bei dieser Ausgestaltung wird der Strom von dem zweiten Submodulanschluss des ersten Submoduls zu dem ersten Submodulanschluss des zweiten Submoduls vollständig über das Kühlkörperteil geleitet.

Alternativ können die ersten Hauptanschlüsse der Schaltelemente über eine auf das zugeordnete Kühlkörperteil aufgebrachte elektrisch leitfähige Schicht mit dem Kühlkörperteil verbunden sein. Bei dieser Ausgestaltung wird der Strom von dem zweiten Submodulanschluss des ersten Submoduls zu dem ersten Submodulanschluss des zweiten Submoduls teilweise über das Kühlkörperteil und teilweise über die leitfähige Schicht geleitet. Das Vorsehen der elektrisch leitfähigen Schicht kann z.B. aus Gründen einer einfacheren Fertigung vorgesehen sein. Der Wärmeübergang zu dem Kühlkörperteil wird durch die elektrisch leitfähige Schicht nicht oder kaum beeinflusst.

Die leitfähige Schicht kann als Metallschiene ausgebildet sein, die mit einem jeweiligen Kühlkörperteil verbunden ist. Dies bedeutet, jedem Kühlkörperteil ist eine solche Metallschiene zugeordnet.

Gemäß einer weiteren zweckmäßigen Ausgestaltung ist die Anzahl der Kühlkörper um eins ("1") größer als die Anzahl der Halbbrücken-Submodule. Dadurch kann auch die Wärme von den Schaltelementen effizient abgeführt werden, welche mit den Eingangsanschlüssen des Umrichters verschaltet sind und jeweils alleine auf einem eigenen Kühlkörperteil in der oben beschriebenen Weise angeordnet sind.

Gemäß einer weiteren zweckmäßigen Ausgestaltung umfassen die Kühlkörperteile Kühlflächen. Z.B. können die Kühlkörperteile Kühlrippen umfassen, welche von Luft umströmbar sind. Alternativ oder zusätzlich können die Kühlkörperteile von einem Kühlmittel durchströmbar sein. Dadurch ist eine besonders effiziente Wärmeabfuhr von den Schaltelementen möglich. Hierzu können die Kühlkörperteile jeweils von einer Flüssigkeit durchströmt sein oder werden. Die Kühlkörperteile können auch mit sogenannten Heat-Pipes ausgestattet sein, in denen - wie dem Fachmann bekannt ist - ein Gas verdampft wird, so dass durch entstehende Verdunstungskälte dem Kühlkörperteil Wärme entzogen wird. Das verdampfte Gas kondensiert an z.B. luftgekühlten Kühlrippen und wird, z.B. durch Schwerkraft, wieder in Richtung des Teils des Kühlkörperteils geführt, an dem das zu kühlende Schaltelement angeordnet ist.

Gemäß einer weiteren zweckmäßigen Ausgestaltung können die Kühlkörperteile des Kühlkörpers in einer Ebene angeordnet sein. Hierdurch ergibt sich ein, in seinem Aufbau, flacher Umrichter.

Alternativ können die Kühlkörperteile des Kühlkörpers übereinander angeordnet sein, wobei die einem Kühlkörperteil zugeordneten Schaltelemente auf gegenüberliegenden Hauptflächen des zugeordneten Kühlkörperteils angeordnet sind. Dies ermöglicht eine einfache Herstellung des Umrichters, da die in einem solchen Verband angeordneten Komponenten durch Verpressen miteinander verbunden werden können.

Eine weitere zweckmäßige Ausgestaltung sieht vor, dass die elektrische Verbindung, d.h. der Knotenpunkt, zwischen dem zweiten Hauptanschluss des ersten Schaltelements und dem ersten Hauptanschluss des zweiten Schaltelements eines jeweiligen Submoduls über eine oder mehrere Leiterbahnen des Schaltungsträgers des Submoduls realisiert ist. Hierzu kann der Schaltungsträger beispielsweise sog. Dickleiterbahnen (d.h. Leiterbahndicken von größer als 400 µm) aufweisen.

Eine weitere Ausgestaltung sieht vor, dass zwischen den zwei Eingangsanschlüssen pro Phase zwei Inverterarme seriell verschaltet sind, wobei ein Knotenpunkt zwischen den zwei Inverterarmen mit einem Ausgangsanschluss einer Inverterphase gekoppelt ist. Insbesondere umfasst der Umrichter pro Inverterarm und Phase zumindest zwei Submodule.

Gemäß einer weiteren zweckmäßigen Ausgestaltung umfasst ein jeweiliges Submodul eine Halbbrücke mit zwei steuerbaren und seriell verschalteten Schaltelementen. Der erste Submodulanschluss ist elektrisch mit einem ersten Hauptanschluss eines ersten der zumindest zwei Schaltelemente (High-Side-Schaltelement) verbunden. Der zweite Submodulanschluss ist elektrisch mit einem Knotenpunkt eines zweiten Hauptanschlusses des ersten Schaltelements und einem ersten Hauptanschluss eines zweiten der zumindest zwei Schaltelemente (Low-Side-Schaltelement) verbunden.

Gemäß einer weiteren zweckmäßigen Ausgestaltung umfasst das Submodul eine Vollbrücke mit zwei parallel verschalteten Halbbrücken, wobei in einer ersten der Halbbrücken ein erstes und ein zweites Schaltelement in Serie verschaltet sind und in einer zweiten der Halbbrücken ein drittes und ein viertes Schaltelement in Serie verschaltet sind. Der erste Submodulanschluss ist elektrisch mit einem Knotenpunkt eines zweiten Hauptanschlusses des ersten Schaltelements und einem ersten Hauptanschluss des zweiten Schaltelements verbunden. Der zweite Submodulanschluss ist elektrisch mit einem Knotenpunkt eines zweiten Hauptanschlusses des dritten Schaltelements und einem ersten Hauptanschluss des vierten Schaltelements verbunden. Die ersten Hauptanschlüsse des ersten und dritten Schaltelements sind über ein weiteres Kühlkörperteil des Kühlkörpers elektrisch miteinander verbunden.

Die Erfindung wird nachfolgend näher anhand eines Ausführungsbeispiels in der Zeichnung erläutert. Es zeigen:
- Fig. 1: die serielle Verschaltung einer Anzahl von Submodulen zur Bereitstellung einer Inverterphase zwischen einem Eingangsanschluss und einem Ausgangsanschluss;
- Fig. 2: ein elektrisches Ersatzschaltbild eines Halbbrücken-Submoduls;
- Fig. 3: eine schematische Darstellung zweier an einem Kühlkörper angeordneter Halbbrücken-Submodule in einer herkömmlichen Aufbauvariante;
- Fig. 4: eine schematische Darstellung mehrerer Halbbrücken-Submodule an einem Kühlkörper in einer verbesserten Ausgestaltung;
- Fig. 5: eine schematische Darstellung mehrerer Halbbrücken-Submodule an einem mehrere Kühlkörperteile umfassenden Kühlkörper in einer erfindungsgemäßen Ausgestaltung, wobei die Kühlkörperteile in einer Ebene angeordnet sind; und
- Fig. 6: eine schematische Darstellung mehrerer Halbbrücken-Submodule an einem mehrere Kühlkörperteile umfassenden Kühlkörper in einer weiteren erfindungsgemäßen Ausgestaltung, wobei die Kühlkörperteile übereinander gestapelt sind.

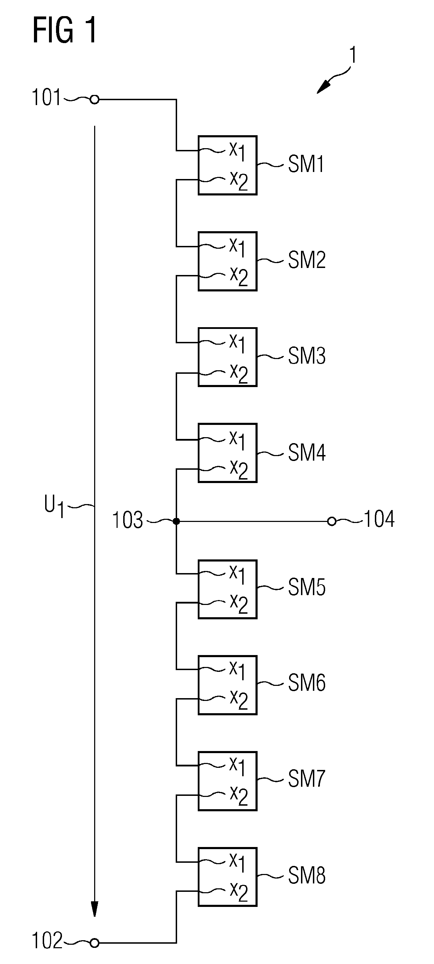

Fig. 1 zeigt eine Inverterphase eines Umrichters in sog. Multilevel-Topologie. Bei diesem sind zwischen einem Eingangsanschluss 101 und einem Eingangsanschluss 102 beispielhaft acht identisch aufgebaute Submodule SM1, ..., SM8 miteinander verschaltet. Ein Knotenpunkt 103 zwischen den Halbbrücken-Submodulen SM4 und SM5 ist mit einem Ausgangsanschluss 104 der Inverterphase verbunden. Die zwischen dem Eingangsanschluss 101 und dem Knotenpunkt 103 verschalteten Submodule SM1, ..., SM4 sind dabei einem oberen Inverterarm zugeordnet. Die zwischen dem Knotenpunkt 103 und dem Eingangsanschluss 102 seriell verschalteten Submodule SM1, ..., SM8 sind einem unteren Inverterarm zugeordnet. Zwischen den Eingangsanschlüssen 101 und 102 liegt eine Gleichspannung U₁ an. Die Eingangsanschlüsse 101, 102 sind Anschlüsse eines hier nicht näher dargestellten Gleichspannungszwischenkreises. Durch eine ebenfalls nicht dargestellte Steuerschaltung, die die in den jeweiligen Submodulen SM1, ..., SM8 enthaltenen Schaltelemente ansteuert und in geeigneter Weise leitend und sperrend schaltet, kann an dem Ausgangsanschluss 104 eine Wechselspannung abgegriffen werden.

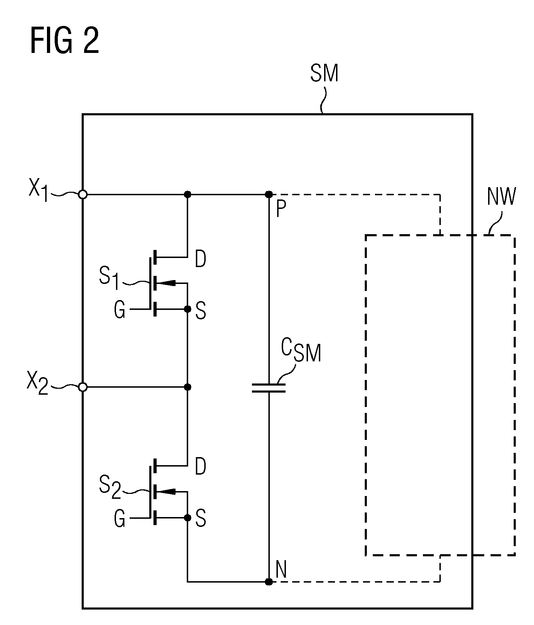

Fig. 2 zeigt ein elektrisches Ersatzschaltbild der identisch aufgebauten Submodule SM1, ..., SM8 in Gestalt eines Halbbrücken-Submoduls. So umfasst jedes der Halbbrücken-Submodule SM zwei seriell verschaltete Schaltelemente S₁, S₂. Bei den Schaltelementen S₁, S₂ handelt es sich beispielsweise um MOSFETs oder andere steuerbare Halbleiterschaltelemente. Der als Drain D bezeichnete erste Hauptanschluss des Schaltelements S₁ ist mit einem ersten Submodulanschluss X₁ verbunden. Der als Source S bezeichnete zweite Hauptanschluss des Schaltelements S₁ ist mit dem Drain-Anschluss D des zweiten Schaltelements S₂ verbunden. Der Knotenpunkt zwischen dem Source-Anschluss S des Schaltelements S₁ und dem Drain-Anschluss des Schaltelements S₂ bildet einen zweiten Submodulanschluss X₂. Der Source-Anschluss des zweiten Schaltelements S₂ ist über einen Kondensator C_{SM} mit dem Drain-Anschluss des ersten Schaltelements S₁ verbunden. Parallel zu dem Kondensator C_{SM} kann an die mit den Bezugszeichen P und N gekennzeichneten Knotenpunkte ein optionales Ausgangsnetzwerk NW angeschlossen sein.

Zur Bereitstellung einer Inverterphase mit Multilevel-Charakteristik, wie diese in Fig. 1 dargestellt ist, werden die Submodulanschlüsse X₁, X₂ der jeweiligen Halbbrücken-Submodule in Serie miteinander verschaltet. So ist, wie dies Fig. 1 unschwer zu entnehmen ist, der erste Submodulanschluss X₁ des Submoduls SM1 mit dem Eingangsanschluss 101 verbunden. Der zweite Submodulanschluss X₂ des Submoduls SM1 ist mit dem ersten Submodulanschluss X₁ des Submoduls SM2 verbunden. Der zweite Submodulanschluss X₂ des Submoduls SM2 ist wiederum mit dem ersten Submodulanschluss des Submoduls SM3 verbunden, usw. Der zweite Submodulanschluss X₂ des Submoduls SM8 ist schließlich mit dem Eingangsanschluss 102 verbunden. Wie ebenfalls unschwer der Fig. 1 zu entnehmen ist, ist der Ausgangsanschluss 104 der Inverterphase des Umrichters 1 über den Knotenpunkt 103 sowohl mit dem zweiten Submodulanschluss X₂ des Submoduls SM4 als auch mit dem ersten Submodulanschluss X₁ des Submoduls SM5 verbunden.

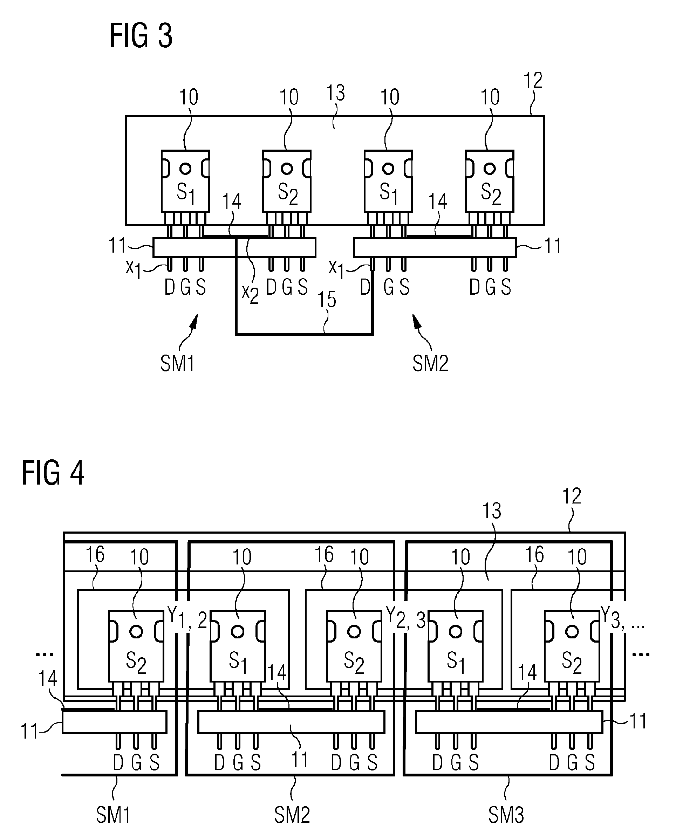

Diese Verschaltung nimmt in dem Umrichter 1 viel Bauraum in Anspruche. Fig. 3 zeigt eine mögliche Aufbauvariante für zwei benachbart auf einem Kühlkörper 12 angeordnete, Leiterplatten-basierte Submodule SM1, SM2. Bei dieser Aufbauvariante ist jedes Submodul SM1, SM2 unter Verwendung von diskreten Leistungshalbleiterschaltelementen und einem Schaltungsträger aufgebaut. Hierdurch ergeben sich im Vergleich zu dem aus dem Stand der Technik bekannten Direct Copper Bonding (DCB) bessere elektrische Eigenschaften.

Die Submodule SM1, SM2 (in entsprechender Weise gilt dies natürlich auch für die weiteren, in Fig. 3 nicht dargestellten Submodule SM3, ..., SM8) umfassen jeweils einen Schaltungsträger 11. Auf den Schaltungsträger 11 sind jeweils zwei Leistungshalbleiterschaltelemente 10 aufgebracht. Jedes der Leistungshalbleiterschaltelemente 10 umfasst drei Kontaktpins, welche durch entsprechende, in Fig. 3 nicht näher dargestellte Öffnungen oder Bohrungen des Schaltungsträgers 11 gesteckt und verlötet sind. Die drei Kontaktpins stellen den Drain-Anschluss D (erster Hauptanschluss), den Source-Anschluss S (zweiter Hauptanschluss) und den Gate-Anschluss G (Steueranschluss) dar. Eine elektrische Verbindung zwischen dem Source-Anschluss des mit S₁ gekennzeichneten Leistungshalbleiterschaltelements 10 und dem Drain-Anschluss des mit S₂ gekennzeichneten Leistungshalbleiterschaltelements 10 erfolgt über eine Leiterbahn 14. Aufgrund des hohen fließenden Stromes kann hierbei die Leiterbahn 14 als Dickkupfer-Leiterbahn ausgebildet sein. Die elektrische Verbindung zwischen dem Source-Anschluss S von S₁ und dem Drain-Anschluss D von S₂ bildet den in Verbindung mit Fig. 2 erläuterten zweiten Submodulanschluss X₂. Der erste Submodulanschluss X₁ ist der Drain-Anschluss D des mit S₁ gekennzeichneten Leistungshalbleiterschaltelements 10.

Die Entwärmung der Leistungshalbleiterschaltelemente 10 erfolgt direkt an deren Drain-Anschlüssen D durch direktes Aufpressen der auf der Rückseite der diskreten Leistungshalbleiterschaltelemente 10 ausgebildeten Drain-Anschlüssen D an den bereits erwähnten Kühlkörper 12. Um einen Kurzschluss der Drain-Anschlüsse D über den Kühlkörper 12 zu vermeiden, ist auf der dem Betrachter zugewandten Seite des Kühlkörpers 12 eine gut wärmeleitende Isolationsschicht 13 aufgebracht. Um einen innigen Kontakt zwischen den Rückseitenkontakten (Drain-Anschlüsse) der Leistungshalbleiterschaltelemente 10 und dem Kühlkörper 12 sicherzustellen, können die Leistungshalbleiterschaltelemente z.B. auf den Kühlkörper 12 aufgeschraubt sein.

Zur Herstellung der elektrischen Verbindung zwischen dem zweiten Submodulanschluss X₂ des Submoduls SM1 und dem ersten Submodulanschluss X₁ des Submoduls SM2 wird bei der Anordnung gemäß Fig. 3 ein Kabel 15 genutzt. Dies wird beispielsweise zwischen entsprechenden Kontaktflächen der Schaltungsträger 11 elektrisch in der in Fig. 3 gezeigten Weise verschraubt. Aufgrund der an den Kontaktstellen auftretenden Stromwärmeverluste zwischen dem Kabel 15 und den betreffenden Schaltungsträgern 11 der Halbbrücken-Submodule SM1, SM2 werden große Kabelquerschnitte und große Kontakte verwendet. Dies führt jedoch dazu, dass die Aufbau- und Verbindungstechnik sehr groß und schwer ausfällt.

Fig. 4 zeigt eine verbesserte Aufbauvariante. In der Darstellung der Fig. 4 sind dabei das Schaltmodul SM1 teilweise sowie die seriell mit diesem verschalteten Schaltmodule SM2 und SM3 dargestellt. Die in Fig. 3 mit dem Bezugszeichen 15 gekennzeichnete elektrische Verbindung ist in der in Fig. 4 gezeigten Aufbauvariante jeweils durch eine leitfähige Schicht 16 ersetzt, welche zwischen den diskreten Leistungshalbleiterschaltelementen 10 und der Isolationsschicht 13 auf dem Kühlkörper 12 angeordnet ist. Dabei sind der Drain-Anschluss des zweiten Schaltelements S₂ eines Halbbrücken-Submoduls (z.B. SM1) und der Drain-Anschluss des ersten Schaltelements S₁ des benachbarten Halbbrücken-Submoduls (SM2) auf der leitfähigen Schicht 16 aufgebracht und elektrisch leitend mit dieser verbunden. In entsprechender Weise ist der Drain-Anschluss des zweiten Schaltelements S₂ des Halbbrücken-Submoduls SM2 und der Drain-Anschluss D des ersten Schaltelements S₁ des benachbarten Halbbrücken-Submoduls (hier: SM3) auf einer anderen leitfähigen Schicht aufgebracht. Auf einer jeweiligen leitfähigen Schicht 16 sind somit jeweils paarweise die Drain-Anschlüsse der Schaltelemente benachbarter Halbbrücken-Submodule aufgebracht.

Durch die ausschließliche Kontaktierung der Drain-Anschlüsse D der diskreten Leistungshalbleiterschaltelemente der Halbbrücken-Submodule SM kann die Serienschaltung der Halbbrücken-Submodule sehr kompakt aufgebaut werden. Insbesondere ergibt sich eine kompakte Serienschaltung mit minimalem Befestigungsaufwand. Es ist eine direkte Kühlung der elektrischen Kontakte und der elektrischen Schichten möglich. Die elektrischen Schichten sind beispielsweise in Gestalt von Metallschienen realisiert.

Der Knotenpunkt bzw. Ausgangsanschluss lässt sich mit Hilfe der leitfähigen Schicht realisieren. So kann die leitfähige Schicht beispielsweise eine von den Schaltungsträgern weg weisende Lasche (nicht gezeigt) aufweisen, so dass im Flächenbereich der Lasche eine Verschraubung oder Steckverbindung zu dem Ausgangsanschluss erfolgen kann.

Es ergibt sich ein verringerter Stromfluss über den jeweiligen Schaltungsträger der Halbbrücken-Submodule, da ein Großteil des Stroms direkt an den Drain-Anschlüssen der Leistungshalbleiterschaltelemente abgenommen wird. Dadurch ergibt sich eine geringere thermische Beanspruchung der jeweiligen Schaltungsträger.

Ermöglicht wird diese Aufbauvariante dadurch, dass alle Kontaktierungsstellen (d.h. die Drain-Anschlüsse der Leistungshalbleiterschaltelemente) gleichzeitig diejenigen Stellen sind, an denen die Wärme der Leistungshalbleiterschaltelemente abgeführt wird. Dadurch erfolgt eine Aufhebung der Trennung zwischen elektrischen und thermischen Pfaden. Vielmehr stimmen diese nunmehr überein.

Die Entwärmung der Halbleiterschaltelemente zum Kühlkörper 12 wird durch die elektrisch leitfähige Schicht 16 nur minimal beeinflusst, da diese mit einem sehr hohen thermischen Leitwert bereitgestellt werden können. Bevorzugt bestehen die leitfähigen Schichten 16 aus Kupfer oder Aluminium oder Legierungen davon.

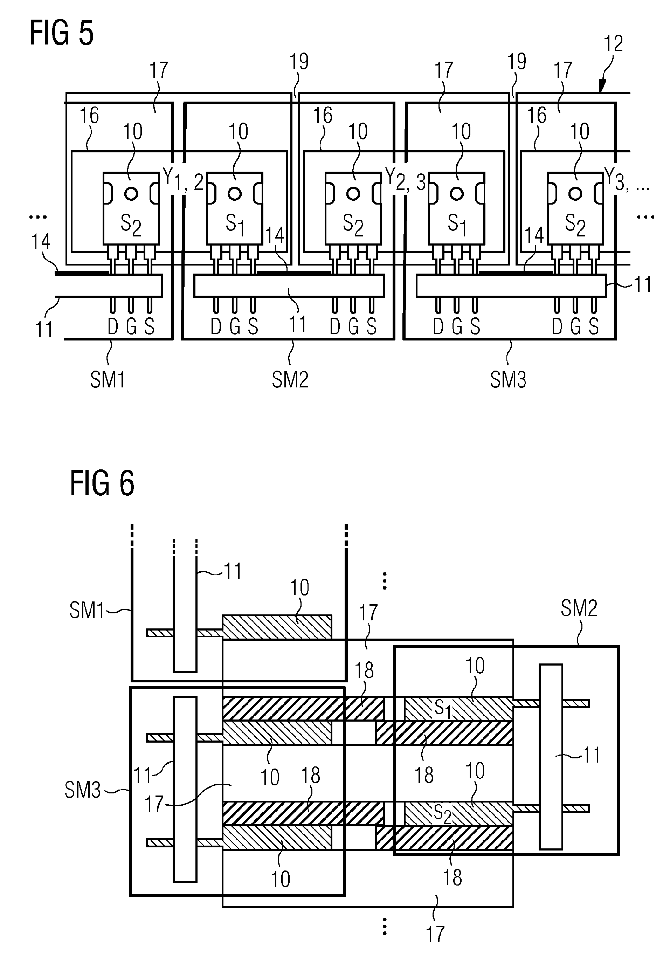

Fig. 5 zeigt eine erfindungsgemäße Aufbauvariante. Diese Aufbauvariante basiert auf dem in Fig. 4 beschriebenen Ausführungsbeispiel. Zur Vermeidung von Wiederholungen werden lediglich Unterschiede zu der in Fig. 4 gezeigten Aufbauvariante beschrieben.

Gemäß der in Fig. 5 gezeigten Aufbauvariante umfasst der Kühlkörper 12 eine Anzahl an Kühlkörperteilen 17. Die Anzahl der Kühlkörperteile 17 ist um eins größer als die Anzahl der Submodule, wenn diese eine Halbbrücke mit zwei steuerbaren und seriell verschalteten Schaltelementen umfassen, wie in sämtlichen Ausführungsbeispielen gezeigt. Die Kühlkörperteile 17 sind beispielhaft durch einen Luftspalt 19 voneinander getrennt. Die Größe des Luftspaltes 19 ist derart bemessen, dass ein zwischen den Kühlkörperteilen auftretender Potentialunterschied nicht zu einem elektrischen Überschlag führt.

Während in der Aufbauvariante gemäß Fig. 4 aufgrund der Verwendung der Isolationsschicht 13 der Kühlkörper von einem Potential der Arbeitsspannung getrennt ist, ist bei dem in Fig. 5 gezeigten Ausführungsbeispiel vorgesehen, die Kühlkörperteile 17 zur Stromleitung zu nutzen. Zu diesem Zweck sind die jeweiligen Leistungshalbleiterschaltelemente 10 mit ihrem ersten Hauptanschluss nicht nur thermisch, sondern auch elektrisch an ein zugeordnetes Kühlkörperteil 17 angeschlossen. Optional kann dabei die in Fig. 5 gezeigte leitfähige Schicht 16 zwischen den ersten Hauptanschlüssen der steuerbaren Leistungshalbleiterschaltelemente 10 und den zugeordneten Kühlkörperteilen 17 vorgesehen sein. Durch den Verzicht auf die Isolationsschicht ist eine wesentlich bessere Entwärmung der Leistungshalbleiterschaltelemente 10 gegeben, da eine direkte Kühlung der elektrischen Kontakte (Drain-Anschlüsse) erfolgen kann.

Die Kühlkörperteile 17 stellen eine gut leitfähige Verschienung dar, und sind daher vorzugsweise aus Kupfer oder Aluminium gebildet. Durch die elektrisch voneinander isolierten Kühlkörperteile 17 wird der Verzicht auf die Isolationsschicht zwischen den Kühlkörperteilen und den ersten Hauptanschlüssen D der Leistungshalbleiterschaltelemente ermöglicht. Durch die Reduktion des Wärmeübergangswiderstands kann dadurch das Leistungsgewicht des Umrichters im Gesamten gesteigert werden.

Da die einzelnen Kühlkörperteile 17 ein Arbeitspotential aufweisen, ist die elektrische Isolation der Kühlkörperteile 17 von Bedeutung. Die funktionale Isolation zwischen den Kühlkörperteilen 17 erfolgt, wie beschrieben, über einen jeweiligen Luftspalt 19 zwischen benachbarten Kühlkörperteilen. Der Luftspalt kann mit einem festen Isolator gefüllt sein. Sollen die Kühlkörperteile mit Flüssigkeit eines gemeinsamen Flüssigkeitskreislaufs gekühlt werden, so wird ein elektrisch nicht leitendes Fluid verwendet, damit kein Kurzschluss über das Kühlmedium verursacht wird.

In dem in Fig. 5 gezeigten Ausführungsbeispiel sind die Kühlkörperteile 17 in einer Ebene nebeneinander angeordnet, so dass sich in Abhängigkeit der Anzahl der Submodule SM1, SM2, SM3, ... ein flacher, länglich ausgebildeter Umrichter ergibt. In einer alternativen Ausgestaltung können die Kühlkörperteile 17 auch übereinander angeordnet werden. Dies ist beispielsweise in dem in Fig. 6 gezeigten Ausführungsbeispiel dargestellt.

In diesem Ausführungsbeispiel sind die auf einen jeweiligen Kühlkörperteil 17 befestigten Leistungshalbleiterschaltelemente 10 nicht nur auf gegenüberliegenden Hauptzeiten des Kühlkörperteils 17, sondern zusätzlich (und lediglich beispielhaft) auch an gegenüberliegenden Enden angeordnet, so dass die Submodule SM1, SM2, SM3 abwechselnd an gegenüberliegenden Stirnseiten der Kühlkörperteile 17 angeordnet sind. Zwischen einem Leistungshalbleiterschaltelement 10 und dem benachbarten Kühlkörperteil 17 ist zudem jeweils eine federnde Isolationsschicht 18 (d.h. eine elektrisch isolierende Schicht) angeordnet, so dass der Aufbau des Umrichters in einem Pressverband realisiert werden kann. In diesem werden die Kühlkörperteile 17 als einzige Verschienung zur Serienschaltung der Leistungshalbleiterschaltelemente genutzt. Bei einem solchen Aufbau ist es ausreichend, den gesamten Verband aus Leistungshalbleiterschaltelementen, Kühlkörperteilen und federnden Isolationsschichten an den äußeren Enden zusammenzupressen. Dadurch wird nicht nur eine einfache Herstellung, sondern auch ein sehr kompakt bauender Umrichter ermöglicht.

Im Falle eines solchen Pressverbands können beispielsweise Heat-Pipes verwendet werden, um Wärme aus den vorzugsweise flach aufgeführten Kühlkörperteilen 17 abzuführen. Um Kurzschlüsse zwischen den Kühlkörperteilen zu vermeiden, wird ein elektrisch nicht leitendes Kühlmedium verwendet. Durch die ausschließliche Kontaktierung der Drain-Anschlüsse D der Halbleiterschaltelemente der Halbbrücken-Submodule SM kann die Serienschaltung der Submodule sehr kompakt aufgebaut werden. Durch den Wegfall der Isolation zwischen den Drain-Anschlüssen D und den Kühlkörperteilen 17 wird die Wärmeabfuhr stark verbessert.

Der in den Abbildungen 5 und 6 beispielhaft skizzierter Aufbau weist folgende Vorteile auf:
Es ist eine kompakte Verschaltung mit minimalem Befestigungsaufwand realisierbar. Die Serienschaltung der Submodule benötigt, wenn diese in einem Stapel wie in Fig. 6 vorliegt, keinerlei Schraub- oder Klemmkontakte auf den Schaltelementen. Bei der Realisierung nach Abb. 5 können Schraub- und Klemmverbindungen zum Einsatz kommen. Eine solche Kontaktierung ist lediglich bei den Submodulen erforderlich oder möglich, welche mit den Eingangsanschlüssen 101, 102 des Umrichters verbunden sind.

Durch die direkte Kühlung der elektrischen Kontakte und der Verschienungen ergibt sich eine optimierte Wärmeabfuhr von den Leistungshalbleiterschaltelementen. Die Kühlkörperteile werden selbst als elektrische Verschienung benutzt, wodurch die eigentliche Verschienung minimal ausfallen oder sogar entfallen kann. Dadurch lassen sich kleine und kompakte Umrichter realisieren. Ein Aufbau als kompakter Pressverband ist möglich.

Es ergibt sich darüber hinaus ein verringerter Stromfluss über den jeweiligen Schaltungsträger der Halbbrücken-Submodule, da ein Großteil des Stroms direkt an den Drain-Anschlüssen der Leistungshalbleiterschaltelemente abgenommen wird. Dadurch ergibt sich eine geringe thermische Beanspruchung der jeweiligen Schaltungsträger.

Die in den Fig. 5 und 6 vorgeschlagene Kontaktierungsart ist auch in SMD (Surface Mounted Device)-Bauweise realisierbar.

In dem vorliegenden Ausführungsbeispiel wurde die Erfindung in den Figuren 2 bis 6 anhand von Halbbrücken-Submodulen einer Inverterphase beschrieben. Das erfindungsgemäße Prinzip lässt sich ohne weiteres auch auf Vollbrücken-Submodule übertragen. Ein Vollbrücken-Submodul umfasst vier Schaltelemente in zwei parallelen Pfaden, wobei je Pfad zwei der Schaltelemente seriell miteinander verschaltet sind. Bei einem solchen Vollbrücken-Submodul sind die Drain-Anschlüsse der beiden High-Side-Schaltelemente auf einem gemeinsamen, elektrisch leitenden Kühlkörperteil verschaltet. Die Low-Side-Schaltelemente sind mit Schaltelementen zweier jeweils benachbarter Vollbrücken-Submodule über ein weiteres Kühlkörperteil verbunden.

## Patentansprüche

1. Umrichter zur Umwandlung einer zwischen zwei Eingangsanschlüssen (101, 102) anliegenden Eingangsspannung (U₁) in eine Wechselspannung mit vorbestimmter Amplitude und Frequenz für die Ansteuerung einer ein- oder mehrphasigen Last, mit zumindest zwei seriell miteinander verschalteten Submodulen (SM; SM1,...,SM8) eines Inverterarms, wobei jedes Submodul (SM; SM1,...,SM8) folgendes umfasst:
- einen Schaltungsträger (11);
- zumindest zwei steuerbare Schaltelemente (S₁, S₂), die auf dem Schaltungsträger (11) elektrisch miteinander verschaltet sind;
- einen ersten Submodulanschluss (X₁);
- einen zweiten Submodulanschluss (X₂);
bei dem
- erste Hauptanschlüsse (D) der steuerbaren Schaltelemente (S₁, S₂) der zumindest zwei Submodule (SM; SM1,...,SM8) thermisch flächig an eine Kühlfläche eines Kühlkörpers (12) angeschlossen sind;
- der zweite Submodulanschluss (X₂) eines ersten der zumindest zwei Submodule (SM; SM1,...,SM8) mit dem ersten Submodulanschluss (X₁) eines zweiten der zumindest zwei Submodule (SM; SM1,...,SM8) verbunden ist;
**dadurch gekennzeichnet, dass**
- der Kühlkörper (12) eine Anzahl an Kühlkörperteilen (17) umfasst, wobei die Kühlkörperteile (17) elektrisch voneinander isoliert sind; und
- die elektrische Verbindung des zweiten Submodulanschlusses (X₂) des ersten Submoduls (SM; SM2,...,SM8) mit dem ersten Submodulanschluss (X₁) des zweiten Submoduls (SM; SM1,...,SM7) über ein jeweiliges zugeordnetes Kühlkörperteil (17) des Kühlkörpers (12) realisiert ist.

2. Umrichter nach Anspruch 1, **dadurch gekennzeichnet, dass** die ersten Hauptanschlüsse (D) der Schaltelemente (S₁, S₂) Flächenkontakte sind, die vollflächig auf das zugeordnete Kühlkörperteil (17) aufgebracht sind.

3. Umrichter nach Anspruch 1 oder 2, **dadurch gekennzeichnet, dass** die ersten Hauptanschlüsse (D) der Schaltelemente (S₁, S₂) kraftschlüssig und/oder stoffschlüssig mit dem zugeordneten Kühlkörperteil (17) verbunden sind.

4. Umrichter nach einem der Ansprüche 1 bis 3, **dadurch gekennzeichnet, dass** die ersten Hauptanschlüsse (D) der Schaltelemente (S₁, S₂) unmittelbar mit dem zugeordneten Kühlkörperteil (17) verbunden sind.

5. Umrichter nach einem der Ansprüche 1 bis 3, **dadurch gekennzeichnet, dass** die ersten Hauptanschlüsse (D) der Schaltelemente (S₁, S₂) über eine auf den zugeordneten Kühlkörperteil (17) aufgebrachte leitfähige Schicht (16) mit diesem verbunden sind.

6. Umrichter nach Anspruch 5, **dadurch gekennzeichnet, dass** die leitfähige Schicht (16) eine Metallschiene ist.

7. Umrichter nach einem der vorhergehenden Ansprüche, **dadurch gekennzeichnet, dass** die Anzahl der Kühlkörper (12-1,...12-8) um 1 größer ist als die Anzahl der Halbbrücken-Submodule (SM; SM1,..., SM8).

8. Umrichter nach einem der vorhergehenden Ansprüche, **dadurch gekennzeichnet, dass** die Kühlkörperteile (17) Kühlflächen umfassen und/oder von einem Kühlmittel durchströmbar sind.

9. Umrichter nach einem der Ansprüche 1 bis 8, **dadurch gekennzeichnet, dass** die Kühlkörperteile (17) des Kühlkörpers (12) in einer Ebene angeordnet sind.

10. Umrichter nach einem der Ansprüche 1 bis 8, **dadurch gekennzeichnet, dass** die Kühlkörperteile (17) des Kühlkörpers (12) übereinander angeordnet sind, wobei die einem Kühlkörperteil (17) zugeordneten Schaltelemente (S₁, S₂) auf gegenüberliegenden Hauptflächen des zugeordneten Kühlkörperteils (17) angeordnet sind.

11. Umrichter nach einem der vorhergehenden Ansprüche, **dadurch gekennzeichnet, dass** die elektrische Verbindung zwischen dem zweiten Hauptanschluss (S) des ersten Schaltelements (S₁) und dem ersten Hauptanschluss (D) des zweiten Schaltelements (S₂) eines jeweiligen Halbbrücken-Submoduls (SM; SM1,...,SM8) über eine oder mehrere Leiterbahnen des Schaltungsträgers (11) des Halbbrücken-Submoduls realisiert ist.

12. Umrichter nach einem der vorhergehenden Ansprüche, **dadurch gekennzeichnet, dass** zwischen den zwei Eingangsanschlüssen pro Phase zwei Inverterarme seriell verschaltet sind, wobei ein Knotenpunkt zwischen den zwei Inverterarmen mit einem Ausgangsanschluss einer Inverterphase gekoppelt ist.

13. Umrichter nach Anspruch 12, **dadurch gekennzeichnet, dass** dieser pro Inverterarm und Phase zumindest zwei Submodule (SM; SM1,..., SM8) umfasst.

14. Umrichter nach einem der Ansprüche 1 bis 13, **dadurch gekennzeichnet, dass**
- ein jeweiliges Submodul (SM; SM1,...,SM8) eine Halbbrücke mit zwei steuerbaren und seriell verschalteten Schaltelementen (S1, S2) umfasst;
- der erste Submodulanschluss (X1) elektrisch mit einem ersten Hauptanschluss (D) eines ersten der zumindest zwei Schaltelemente (S1, S2) verbunden ist;
- der zweite Submodulanschluss (X2) elektrisch mit einem Knotenpunkt eines zweiten Hauptanschlusses (S) des ersten Schaltelements (S1) und einem ersten Hauptanschluss (D) eines zweiten der zumindest zwei Schaltelemente (S2) verbunden ist.

15. Umrichter nach einem der Ansprüche 1 bis 13, **dadurch gekennzeichnet, dass**
- das Submodul (SM; SM1,...,SM8) eine Vollbrücke mit zwei parallel verschalteten Halbbrücken umfasst, wobei in einer ersten der Halbbrücken ein erstes und ein zweites Schaltelement in Serie verschaltet sind und in einer zweiten der Halbbrücken ein drittes und ein viertes Schaltelement in Serie verschaltet sind;
- der erste Submodulanschluss (X₁) elektrisch mit einem Knotenpunkt eines zweiten Hauptanschlusses (S) des ersten Schaltelements und einem ersten Hauptanschluss (D) des zweiten Schaltelements verbunden ist;
- der zweite Submodulanschluss (X₂) elektrisch mit einem Knotenpunkt eines zweiten Hauptanschlusses (S) des dritten Schaltelements und einem ersten Hauptanschluss (D) des vierten Schaltelements verbunden ist;
- die ersten Hauptanschlüsse (D) des ersten und dritten Schaltelements über ein weiteres Kühlkörperteil (17) des Kühlkörpers (12) elektrisch miteinander verbunden sind.
